# EUROPEAN PATENT APPLICATION

(11) **EP 0 715 345 A1**
(43) Date of publication of application: **05.06.1996**
(21) Application number: 95308345.8
(22) Date of filing: 21.11.1995
(51) Int. Cl.: H01L 21/3205, H01L 29/92

(54) **Integrated circuit capacitor fabrication**

(30) Priority: 30.11.1994 US 347547
(71) Applicant: AT&T Corp., New York, NY 10013-2412 (US)
(72) Inventor: Yu, Chen-Hua Douglas, Orlando, Florida 32836 (US)
(74) Representative: Johnston, Kenneth Graham

(57) **Abstract**

An integrated circuit having an integral capacitor and a method for its formation are disclosed. A metal runner 131 is covererd by an oxide layer 191 of uniform thickness. The oxide layer 191 is covered by a patterned conductor 141, illustratively, titanium nitride. Then, a second level dielectric 151 is deposited. A window is opened in the dielectric 151 above the titanium nitride 141 to provide for electrical contact to the titanium nitride 141. A method of forming contacts is also disclosed.

## Description

### Technical Field

This invention relates to semiconductor integrated circuits and the methods for their fabrication.

### Background of the Invention

Many semiconductor integrated circuits utilize capacitors. However, capacitor formation within an integrated circuit presents a variety of unique problems.

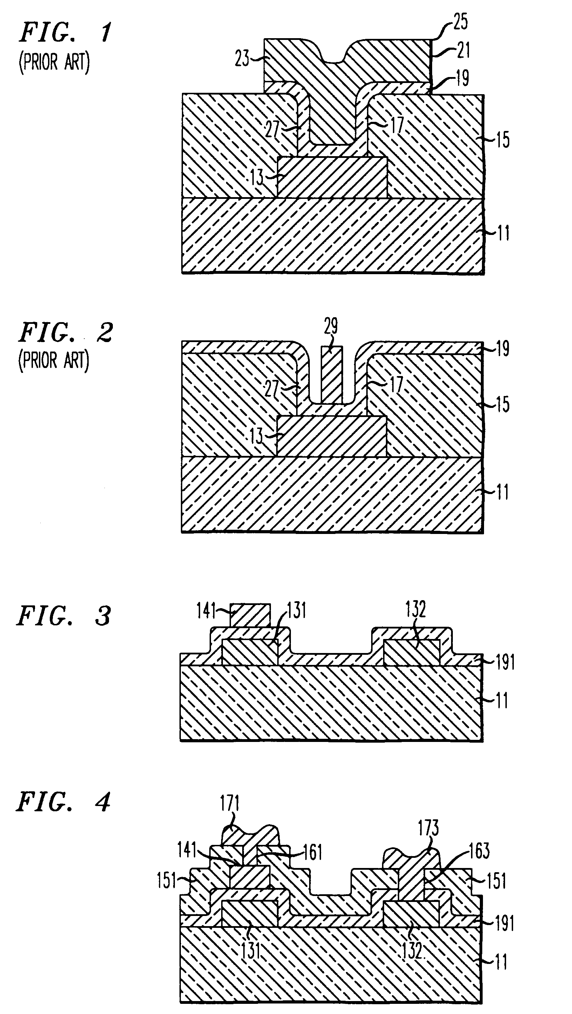

FIG. 1 illustrates a typical integrated circuit capacitor. Substrate 11 may typically be a dielectric, such as silicon dioxide. Reference numeral 13 denotes a patterned metallic runner. Reference numeral 15 denotes a dielectric which is formed in contact with dielectric 11 and which surrounds and covers metal runner 13. Window 17 is subsequently opened within dielectric 15. Window 17 exposes metal runner 13. Next, capacitor dielectric 19 is blanket deposited and subsequently patterned. Finally, metallic runner 21 is deposited and patterned. (Patterning of layers 21 and 19 may be accomplished in a single step if desired.) Thus, as can be appreciated from FIG. 1, a capacitor having metallic plates 13 and 21 (i.e. runners 13 and 21) with intervening dielectric 19 has been formed. The structure depicted in FIG. 1 and the process for creating the structure of FIG. 1 may cause a variety of problems. First, precise control of the thickness of dielectric 19 may be difficult, because after patterning of dielectric 19, sodium removal steps (which typically involve exposure to a eight etchant) may reduce the thickness of layer 19 by as much as 20 percent. Typically, the initial thickness of layer 19 may be 500Å. A 20 percent reduction may significantly affect capacitance. Second, the capacitance of a device depicted in FIG. 1 is difficult to precisely control. The capacitance depends upon the mathematical inverse of the dielectric thickness. As can be seen from FIG. 1, the capacitance at the bottom of window 17 depends only upon the thickness of dielectric 19. However, the capacitance of those portions on the capacitor beneath the extreme left and right sides of metal runner 21 (i.e., sides 23 and 25 respectively) depends, not only upon the thickness of dielectric 19, but also upon the thickness of dielectric 15. Should runner 21, after patterning, be slightly misaligned with respect to window 17 (i.e., not precisely centered over window 17) then the capacitance of the entire capacitor may be affected by the misalignment. Finally, corners of window 17, depicted by reference numeral 27 may not be adequately filled with a sufficiently dense dielectric material. These corners, often termed "soft corners" produce leaky oxides and thereby deficient capacitors.

FIG. 2 depicts another capacitor design. As in FIG. 1, substrate 11 supports metal runner 13. Runner 13 is exposed by window 17. Dielectric 19 has been subsequently formed within window 17. However, in FIG. 2, the upper metal plate 29 has been patterned so that it fits completely within window 17. (Further subsequent processing may include blanket dielectric deposition and opening of a contact window to plate 29.) Consequently, the problems of misalignment of the upper plate and possibly the problem of soft corners mentioned above have been alleviated. However, the design of FIG. 2 presents additional problems. The etching of the blanket metallic layer which was deposited to form upper metal plate 29 may inadvertently create stringers which will short other portions of the circuit. In addition, oxide 19 is exposed during the etching of the blanket metal layer to create upper plate 29. The etching process may inadvertently etch through thin oxide 19, thereby damaging the capacitor.

Those concerned with the developments of capacitors in integrated circuits have consistently sought new and better structures and methods for their fabrication.

### Summary of the Invention

The present invention illustratively includes forming an integrated circuit by forming a first patterned conductor overlying a substrate and forming a first blanket dielectric layer over the conductor and over the substrate. Then a second patterned conductor is formed over the first dielectric and over the first patterned conductor. A second blanket dielectric layer is formed over the second patterned conductor and over the first blanket dielectric. A window is opened in the second blanket dielectric, thereby exposing the second patterned conductor. Then a third patterned conductor is formed in the window and contacting the second patterned conductor.

Illustratively, the first and second patterned conductors are plates of a capacitor and the first blanket dielectric is the capacitor dielectric.

### Brief Description of the Drawings

FIGs. 1, 2, 3 and 4 are cross-sectional views of partially integrated circuits, useful in understanding an illustrative embodiment of the invention.

### Detailed Description

Turning to FIG. 3, reference numeral 11 denotes a dielectric layer which may, illustratively, be silicon dioxide. Layer 11 may cover and surround the basic components of a MOS transistor, such as the gate and silicon substrate or may cover the basic components of a bipolar transistor. Illustratively, dielectric 11 may be formed by the decomposition of TEOS or another precursor.

Metal runners 131 and 132 are formed by patterning a previously-deposited blanket metal layer atop layer 11. Illustratively, metal runners 131 and 132 may be aluminum, aluminum with small amounts of copper and/or silicon, or multi-layer conductors such as titanium nitride and/or titanium tungsten and/or other conducting materials, possibly interlayered with aluminum or other metals. In addition, other conductive materials such as tungsten, molybdenu, copper, etc., may be utilized. Polysilicon may also be utilized.

Dielectric 191 is then blanket deposited over conductors 131 and 132 as well as over dielectric 11. Illustratively, the thickness of dielectric 191 may be between 200 and 1000Å. For example, dielectric 191 may be formed by the decomposition of TEOS or other precursor materials.

Reference numeral 141 denotes a layer of patterned conductive material, such as titanium nitride. The titanium nitride layer is patterned to have a width slightly less than the width of conductor 131, so that, should misalignments occur, there will be no change in final capacitance. Typically, the thickness of layer 141 may be between 300 and 1000Å. Titanium nitride may be etched with dry etch processes which exhibit good selectivity to oxide 191. Other conductive materials may be used.

Turning to FIG. 4, dielectric 151 has been formed, typically by deposition from TEOS or another precursor. Windows 161 and 163 are subsequently opened in dielectric 151. (Window 163 penetrates dielectric 191.) Metal conductor 171 is deposited within window 161 and metal conductor 173 is deposited within window 163. Illustratively, metal conductors 171 and 173 may be formed by the blanket deposition of conductive materials such as aluminum and the subsequent patterning of the conductive material. Other conductive materials suggested above may be used, including polysilicon, tungsten, copper and multilayer conductors such as titanium nitride, titanium tungsten aluminum, etc.

Thus, an examination of FIG. 4 reveals that on the left-hand side, a capacitor has been created. The capacitor plates are conductors 131 and 141 and the capacitor dielectric is layer 191. In addition, on the right-hand side of FIG. 4, a contact has been made to conductor 132 (which may typically be a first level metal conductor).

Thus, an integrated process has been disclosed which provides for the formation of capacitors as well as for connection between various levels of metal conductors in an integrated circuit. The present invention avoids the problems of misalignment, soft corners, and parasitic capacitances discussed previously in connection with FIG. 1; the present invention also avoids the problems of metal stringers and oxide penetration discussion in connection with FIG. 2. Furthermore, since capacitor dielectric 191 is not formed within a window, control of the thickness of oxide 191 is easily achieved.

## Claims

1. A method for forming an integrated circuit comprising:
forming a first patterned conductor 131 overlying a substrate 11;
forming a first blanket dielectric layer 191 over said conductor 131 and over said substrate 11;
forming a second patterned conductor 141 over said first dielectric 191 and over said first patterned conductor 131;
forming a second blanket dielectric layer 151 over said second patterned conductor 141 and over said first blanket dielectric 191;
opening a window 161 in said second blanket dielectric 151, thereby exposing said second patterned conductor 141;
forming a third patterned conductor 171 in said window 161 and contacting said second patterned conductor 141.

2. The method of claim 1 in which said first patterned conductor 131 is formed in contact with an underlying dielectric which contacts said substrate.

3. The method of claim 1 in which said second patterned conductor 141 is formed from titanium nitride.

4. The method of claim 1 in which said first patterned conductor 131 is made from a material chosen from the group consisting of aluminum, copper, titanium nitride, titanium tungsten, tungsten, molybdenum and copper.

5. The method of claim 1 in which said third conductor 171 is made from a material chosen from the group consisting of aluminum, copper, titanium nitride, titanium tungsten, tungsten, molybdenum and copper.

6. An integrated circuit having a capacitor comprising:
a first patterned conductor 131 having a top and sides and having a width upon a substrate;
a first dielectric 191 covering said top and sides of said conductor 131;
a second patterned conductor 141 having a width less than the said width of said first patterned conductor 131 and being positioned on top of said first dielectric 191 and over said first patterned conductor 131.

7. The circuit of claim 6 further including:
a second dielectric 151 covering a portion of said first dielectric 191 and covering a portion of said second conductor 141, said second dielectric 151 having an opening exposing a portion of said second conductor 141;
a third conductor 171 filling said opening and contacting said second conductor.

8. The circuit of claim 6 wherein said second patterned conductor 141 is formed from titanium nitride.

9. The circuit of claim 6 in which said first patterned conductor 131 is made from a material chosen from the group consisting of aluminum, copper, titanium nitride, titanium tungsten, tungsten, molybdenum and copper.

10. The method of claim 1 in which said third conductor 171 is made from a material chosen from the group consisting of aluminum, copper, titanium nitride, titanium tungsten, tungsten, molybdenum and copper.
